# EUROPEAN PATENT APPLICATION

(11) **EP 1 428 905 A1**
(43) Date of publication of application: **16.06.2004**
(21) Application number: 02751788.7
(22) Date of filing: 30.07.2002
(51) Int. Cl.: C23C 14/34, C23C 14/40

(54) **SPUTTERING DEVICE**

(30) Priority: 07.08.2001 JP 2001239028
(71) Applicant: Nippon Sheet Glass Co., Ltd., Osaka-shi, Osaka 541-0041 (JP)
(72) Inventor: MATSUMOTO, Toshiyuki, Nippon Sheet Glass Co., Ltd, Osaka-shi, Osaka 541-0041 (JP); OGINO, Etsuo, Nippon Sheet Glass Co., Ltd, Osaka-shi, Osaka 541-0041 (JP); ISHII, Norimasa, Nippon Sheet Glass Co., Ltd, Osaka-shi, Osaka 541-0041 (JP)
(74) Representative: Wilson Gunn M'Caw
(86) International application number: PCT/JP2002/007719
(87) International publication number: WO 2003/014410

(57) **Abstract**

A sputtering apparatus comprises a chamber in which at least one object to be deposited by a film is movably provided; a plural sets of cathodes are arranged in the chamber, each set consisting of two cathodes positioned side by side and having an opposite polarity; and a plurality of AC cathode power supplies each connected to corresponding one set of cathodes for generating alternating voltages, frequencies and phases thereof are synchronized so that discharges by means of respective sets of cathodes do not interfere to each other when the alternating voltages are supplied to the cathodes to cause discharges at the same time. To the plural sets of cathodes are supplied alternating voltages whose frequencies and phases are synchronized respectively from the plurality of AC cathode power supplies. Therefore, a discharge is not unstably fluctuated when the plural sets of cathodes generate discharges at the same time.

## Description

### Technical Field

The present invention relates to a sputtering apparatus, particularly to a sputtering apparatus in which alternating voltages are supplied to a plurality of cathodes provided in a chamber by using a plurality of AC cathode power supplies.

### Background Art

A sputtering apparatus has been conventionally known which forms a film by depositing atoms on an object such as a wafer, the atoms being ejected by ions accelerated in a vacuum and bumped onto a target.

A conventional sputtering apparatus comprises cathodes to each thereof a target is provided in a chamber, to the cathodes being connected a DC (direct current)-type or AC (alternating current)-type cathode power.supply. The AC-type cathode power supply is especially characterized in that a stable discharge may be implemented by canceling charges stored on the surface of a cathode by means of an alternating voltage having an opposite polarity.

In this sputtering apparatus, however, when a plurality of AC power supplies are connected to a plurality of cathodes arranged in a chamber, respectively, to generate a glow discharge, a phenomenon such that a discharge is fluctuated unstably is caused.

The phenomenon depends on the slight difference of natural frequencies and slight difference of phases of sine waves generated by oscillators provided in respective AC cathode power supplies. That is, these differences cause the overlapped portions of the peaks or valleys of the sine waves to increase when the sine waves are synthesized, resulting in the fluctuation of a discharge.

The phenomenon of this discharge fluctuation is caused particularly in the case that a plurality of cathodes are arranged in a chamber of the sputtering apparatus such that a plurality of cathodes are oppositely arranged to deposit films on the two objects at the same time.

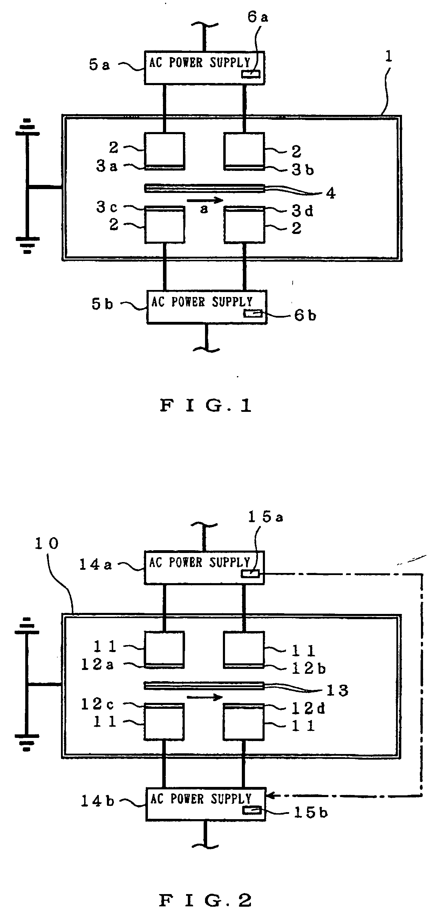

Referring to Fig.1, there is schematically shown a chamber of a conventional sputtering apparatus. As shown in Fig.1, four target backing member (i.e., cathode) 2 are provided in the chamber, targets 3a, 3b, 3c and 3d being attached to respective target backing members 2.

In the figure, two sets of target backing members 2 (each set consists of two target backing members arranged side by side) are arranged oppositely on both sides of two glass substrates 4 which are objects on which films are deposited. The two glass substrates 4 are arranged such that the surface of each substrate is opposed to the targets 3, and are transferred as shown by an arrow a between the targets 3 i.e., between the targets 3a, 3b and targets 3c, 3d.

Two AC power supplies 5a and 5b are provided outside the chamber 1, each of the power supplies comprising an oscillator 6a or 6b. One AC power supply 5a is connected to one of opposed two sets of target backing members 2, and the other AC power supply to the other of opposed two sets of target backing members 2. An alternating voltage is supplied to the target backing members 2 from the AC power supply 5.

That is, one set of target backing members 2 having an opposite polarity and connected to the AC power supply 5a and the other set of target backing members 2 having an opposite polarity and connected to the AC power supply 5b are arranged on both sides of the glass substrates 4 such that each of the target backing members is opposed to the substrates 4.

In the chamber 1, a discharge is generated between two target backing members in every set, respectively. In this case, the interference between two discharges is not avoidable, because respective frequencies of the oscillators 6a and 6b in the AC power supplies 5a and 5b are slightly different. Therefore, the fluctuation phenomenon in a discharge is caused due to the interference of two discharges. The number S (times/second) of fluctuation in a discharge caused by two different frequencies synthesized is given by S=|the frequency of oscillator 6a - the frequency of oscillator 6b|.

It is an object of the present invention to provide a sputtering apparatus in which the discharge does not fluctuate unstably when a plurality of cathodes provided in a chamber generate discharges at the same time, the plurality of cathodes being connected to separate AC power supplies.

### Disclosure of the Invention

A sputtering apparatus according to the present invention comprises a chamber in which at least one object to be deposited by a film is movably provided; a plural sets of cathodes are arranged in the chamber, each set consisting of two cathodes positioned side by side and having an opposite polarity; and a plurality of AC cathode power supplies each connected to corresponding one set of cathodes for generating alternating voltages, frequencies and phases thereof are synchronized so that discharges by means of respective sets of cathodes do not interfere to each other when the alternating voltages are supplied to the cathodes to cause discharges at the same time.

Therefore, a discharge is not unstably fluctuated when the plural sets of cathodes arranged in the same chamber and connected to different AC cathode power supplies respectively generate discharges at the same time, because the alternating voltages are supplied to the plural sets of cathodes from the synchronized plurality of AC cathode power supplies.

### Brief Description of Drawings

Fig.1 shows a chamber of a conventional sputtering apparatus.
Fig.2 shows a chamber of a sputtering apparatus in an embodiment according to the present invention.
Fig.3A shows a wave form of one of two sine waves of different frequencies.
Fig.3B shows a wave form of the other of two sine waves of different frequencies.
Fig.3C shows a wave form of the synthesized wave of the sine waves in Figs.3A and 3B.
Fig.4A shows a wave form of one of two sine waves of different phases.
Fig.4B shows a wave form of the other of two sine waves of different phases.
Fig.4C shows a wave form of the synthesized wave of the sine waves in Figs.4A and 4B.
Fig.5 shows a plan view of a glass substrate used in a discharge experiment in the chamber shown in Fig.2.
Fig.6A shows a wave form of the alternating voltage from one of two AC cathode power supplies used for a discharge experiment in the chamber shown in Fig.2.
Fig.6B shows a wave form of the alternating voltage from the other of two AC cathode power supplies used for a discharge experiment in the chamber shown in Fig.2.
Fig.7A shows a table in which the thickness of a film deposited when the power supplies were synchronous and that of a film deposited when the power supplies were asynchronous are compared.
Fig.7B shows a graph in which the thickness of a film deposited when the power supplies were synchronous and that of a film deposited when the power supplies were asynchronous are compared.
Fig.8A shows an another example 1 of the arrangement of targets in the chamber shown in Fig.2.
Fig.8B shows an another example 2 of the arrangement of targets in the chamber shown in Fig.2.
Fig.8C shows an another example 3 of the arrangement of targets in the chamber shown in Fig.2.

### Best Mode for Carrying Out the Invention

Embodiments of the present invention will now be described with reference to drawings.

Referring to Fig.2, there is shown a chamber of a sputtering apparatus in an embodiment according to the present invention. As shown in Fig.2, the chamber 10 of the sputtering apparatus comprises four backing plate (i.e., cathode) 11 for holding targets, to each backing plate 11 being secured a target 12a, 12b, 12c or 12d.

Two sets of backing plates 11 (each set consists of two backing plates arranged side by side) are arranged oppositely on both sides of two glass substrates 13 which are objects on which films are deposited. The two glass substrates 13 are attached to both sides of a pallet (not shown), respectively, such that the surface of each substrate is opposed to the targets 12, and are transferred as shown by an arrow a between the opposing targets, i.e., the targets 12a, 12b and targets 12c, 12d.

Two AC cathode power supply (AC power supply) 14a and 14b are provided outside the chamber 10, each of the power supplies comprising oscillator 15a or 15b. One AC cathode power supply 14a is connected to one of opposed two sets of backing plate 11, and the other AC cathode power supply 14b to the other of opposed two sets of backing plate 11. An alternating voltage is supplied to the backing plates 11 from the AC cathode power supply 14.

That is, one set of backing plates 11 having an opposite polarity and connected to the AC cathode power supply 14a and the other set of backing plate 11 having an opposite polarity and connected to the AC cathode power supply 14b are arranged on both sides of the glass plates 13 such that each of the backing plates is opposed to the glass substrate 13.

When a sputtering process is carried out in this apparatus, a discharge gas such as Ar is injected into the vacuumed chamber 10 and alternating voltages are supplied to the backing plates. The supplied voltages cause a glow discharge to generate a plasma. Ions in the plasma are bumped onto the targets 12 to eject atoms therefrom.

The separate AC cathode power supplies 14a and 14b supply alternating voltages to the two sets of banking plates 11 arranged oppositely to each other in the chamber 10, respectively, to cause discharges by means of respective banking plates. The fluctuation in a total discharge depends on the synthesizing of two oscillating waves outputted by the oscillators 15 and 15b in the two AC cathode power supplies 14a and 14b.

The fluctuation in a discharge is caused by the difference of frequencies and difference of phases of the two oscillating waves outputted from the two oscillators 15a and 15b. This is also applicable to the case that the two sets of backing plates 11 are not only arranged oppositely but also arranged in a row, and to the case that the number of sets of backing plates 11 and the AC cathode power supplies 14 are more than 2, respectively.

Observing the wave forms of alternating voltages supplied by the two AC cathode power supplies 14a and 14b, it is appreciated that each wave form has a distortion which has a fixed frequency.

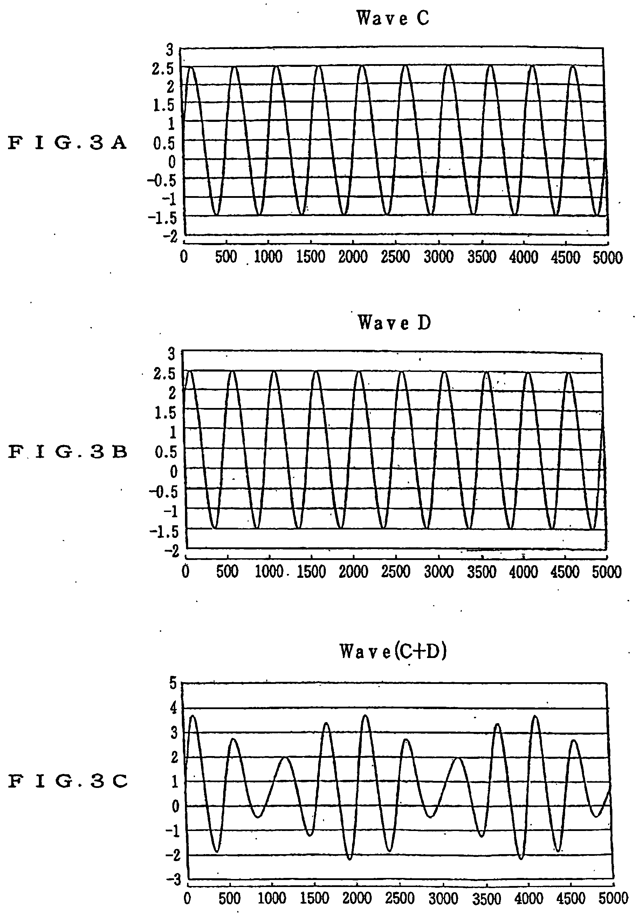

Figs.3A and 3B show wave forms of two sine wave the frequencies thereof are different. Fig.3C shows a wave form of the synthesized wave of the sine waves in Figs.3A and 3B.

Wave A in Fig.3A and wave B in Fig.3B are both sine waves that have the same maximum value and same phase, but the frequencies thereof are slightly different. The synthesized wave of these waves, i.e., wave (A+B) shown in Fig.3C is varied with a fixed periodicity.

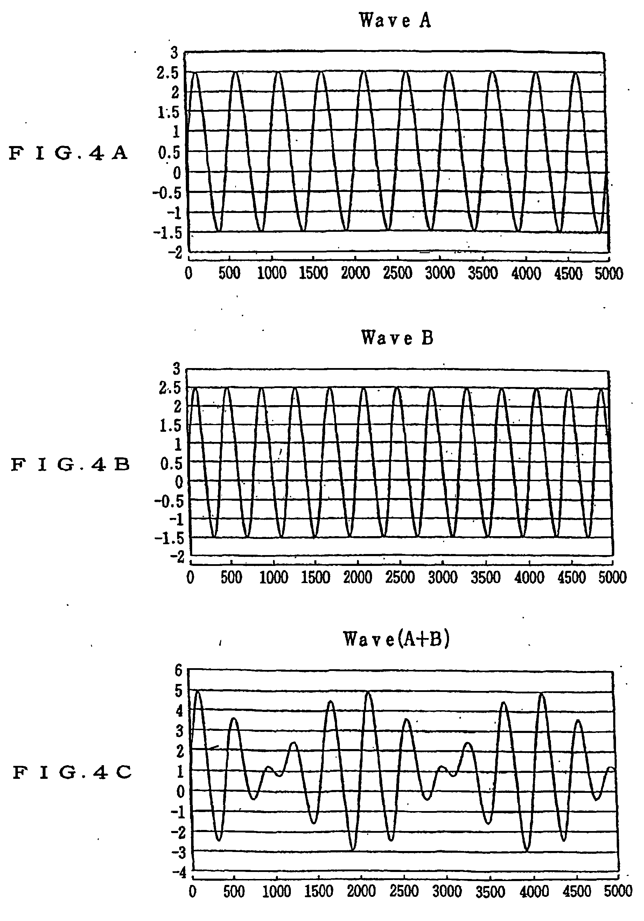

Figs.4A and 4B show wave forms of two sine waves the phases thereof are different. Fig.4C shows a wave form of the synthesized wave of the sine waves in Fig.4A and 4B.

Wave C in Fig.4A and wave D in Fig.4B are both sine waves that have the same maximum value and same frequency, but the phases thereof are slightly different. The synthesized wave of these sine waves, i.e., wave (C+D) shown Fig.4C is varied with a fixed periodicity.

This variation of the synthesized wave is matched to the fluctuation phenomenon of a plasma discharge, i.e., the repetition of light and dark of the discharge. This means that the fluctuation of a plasma discharge depends on the difference of frequencies or phases of the waves of alternating voltages from the two AC cathode power supplies 14a and 14b. The fluctuation phenomenon of a plasma discharge have an effect on a deposition rate and may cause a stable deposition to be impossible.

It is therefore required that the frequency difference and phase difference of the oscillating waves must be zero by synchronizing the oscillators 15a and 15b provided in the two AC cathode power supplies 14a and 14b. That is, when there are a plurality of AC cathode power supplies, it is required that the alternating voltages from power supplies must be synchronized in order to realize a non-fluctuation discharge.

In order to realize this, the oscillator provided in a representative AC cathode power supply (i.e., a master power supply) is selected as a reference oscillator, and the oscillators provided in other AC cathode power supplies (i.e., slave power supplies) is not used. That is, the oscillating wave from the reference oscillator is applied to the slave power supplies, then the slave power supply generates an alternating voltage using the reference oscillator provided in the master power supply.

Next, a result of a discharge experiment will now be illustrated in a sputtering apparatus in which two sets of targets 12 were oppositely arranged in the chamber 10 as shown in Fig.2. AC cathode power supply 14a was connected to the backing plates 11 holding the targets 12a and 12b, and AC cathode power supply 14b was connected to the backing plates 11 holding the targets 12c and 12d. Each target 12 was made of Si. Ar gas flow rate was 640sccm, and O₂ gas flow rate was 320sccm. A discharge power was 3.30kW.

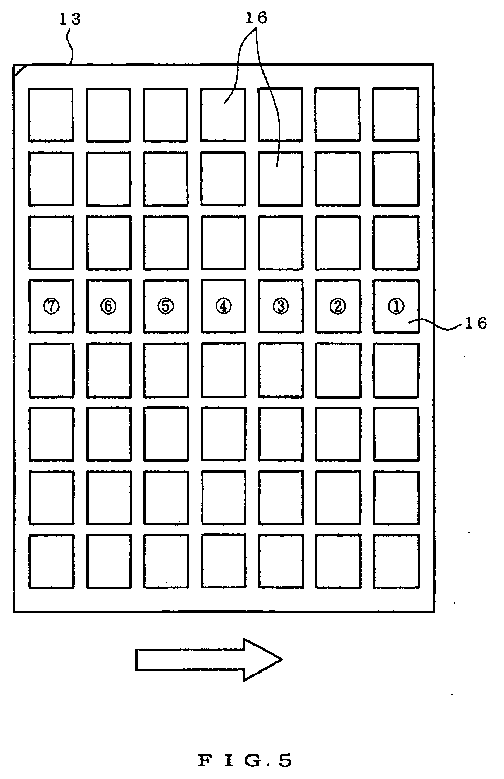

Referring to Fig.5, there is shown a plan view of a glass substrate used in the discharge experiment in the chamber shown in Fig.2. The glass substrate 13 to be deposited consisted of a soda-lime glass of about 0.5mm thickness, on the surface thereof were arranged a plurality of chips 16 in a matrix array of 8 rows×7 columns. The row direction was a proceeding direction (shown by an arrow) of the substrate in the figure.

The glass substrate 13 was transferred in the chamber 10 at the rate of about 21cm/minute so that the chips designated by ① to ⑦ passed in this order between the targets 12a and 12b oppositely arranged (see Fig.2).

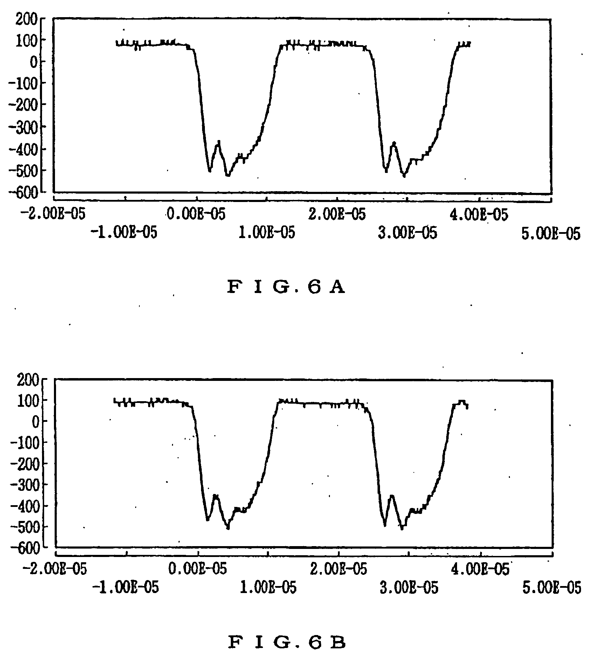

Referring to Fig.6A, there is shown a wave form of the alternating voltage from one of two AC cathode power supplies used for a discharge experiment in the chamber shown in Fig.2. Referring to Fig.6B, there is shown a wave form of the alternating voltage from the other of two AC cathode power supplies used for a discharge experiment in the chamber shown in Fig.2. These alternating voltage waves were measured by using a probe of 1:1000.

In Fig.6A, the frequency of alternating voltage from the AC cathode power supply 14a was 40000Hz, the power supply being connected to the backing plates 11 holding the targets 12a and 12b, respectively. In Fig.6B, the frequency of alternating voltage from the AC cathode power supply 14b was 39998Hz, the power supply being connected to the backing plates 11 holding the targets 12c and 12d, respectively. The difference between these frequencies of alternating voltage from the AC cathode power supplies 14a and 14b was 2Hz.

In this situation, the fluctuation phenomenon for a discharge at a rate of about two times/second was observed. When the thickness of films deposited on the glass substrates 13 was measured, it was appreciated that the thickness of the films was not uniform because of a distribution of the thickness thereof across the surface of the chip.

In order to avoid this, the two AC cathode power supplies 14a and 14b were synchronized according to the present invention. That is, one power supply 14a and the other power supply 14b were selected as a master and slave, respectively, so that the two AC cathode power supplies 14a and 14b were both operated by the oscillator 15a of the master power supply 14a. Observing the frequencies of the alternating voltages from the synchronized AC power supplies 14a and 14b by a synchroscope, both of the AC cathode power supplies generated alternating voltages of 40000Hz frequencies.

Observing a discharge by the synchronized two AC cathode power supplies, it was appreciated that the fluctuation phenomenon was not caused and a stable discharge state was realized. The thickness of films deposited on the glass plates was uniform because the thickness thereof was not distributed across the surface of the chip.

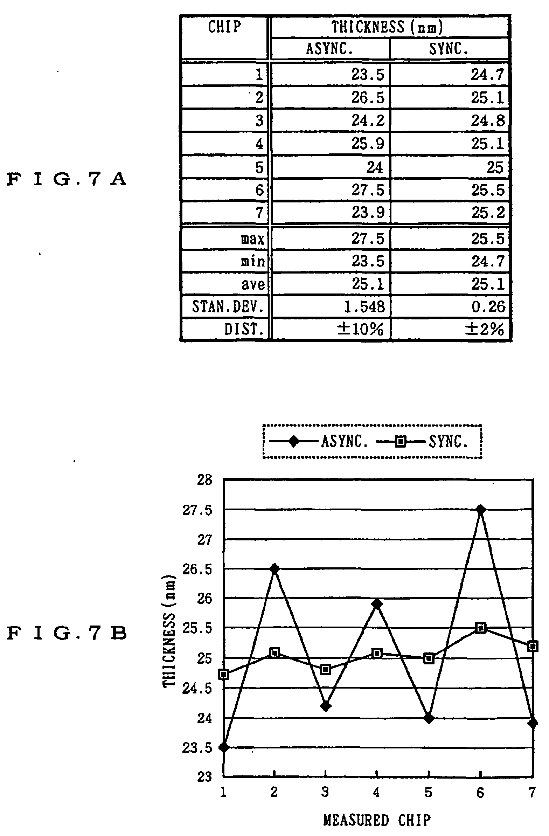

Referring to Fig.7A, there is shown a table in which the thickness of a film deposited when the power supplies were synchronous and that of a film deposited when the power supplies were asynchronous are compared. Referring to Fig.7B, there is shown a graph in which the thickness of a film deposited when the power supplies were synchronous and that of a film deposited when the power supplies were asynchronous are compared.

A SiO₂ film was deposited aiming at 25nm thickness on both sides of the glass substrate 13 shown in Fig.5. The thickness of the deposited film was two-dimensionally measured using a surface roughness analyzer.

As shown in Figs.7A and 7B, the thickness of the film was varied across the chip ① - ⑦. While the thickness was varied from 27.5nm to 23.5nm in the case of the two asynchronous AC cathode AC power supplies 14a and 14b, the thickness was varied from 26.5nm to 24.7nm in the case of the two synchronous AC cathode AC power supplies. The average value was 25.1nm in both cases.

It was appreciated from the comparison result that both of the standard deviation and the distribution of the film thickness was substantially improved. That is, while the standard deviation of the film thickness was 1.548 and the distribution of the film thickness was ±10% for the two asynchronous AC cathode power supplies 14a and 14b, the standard deviation of the film thickness was 0.26 and the distribution of the film thickness was ± 2% for the two synchronous AC cathode power supplies 14a and 14b.

As stated above, synchronizing the two AC cathode power supplies 14a and 14b is effective to the case that two sets of targets 12a, 12b and 12c, 12d are arranged oppositely to deposit films on the two substrates arranged back to back (see Fig.2.). Also, synchronizing a plurality of AC cathode power supplies 14 is effective to the case that targets 12 are arranged in a row in the chamber 10.

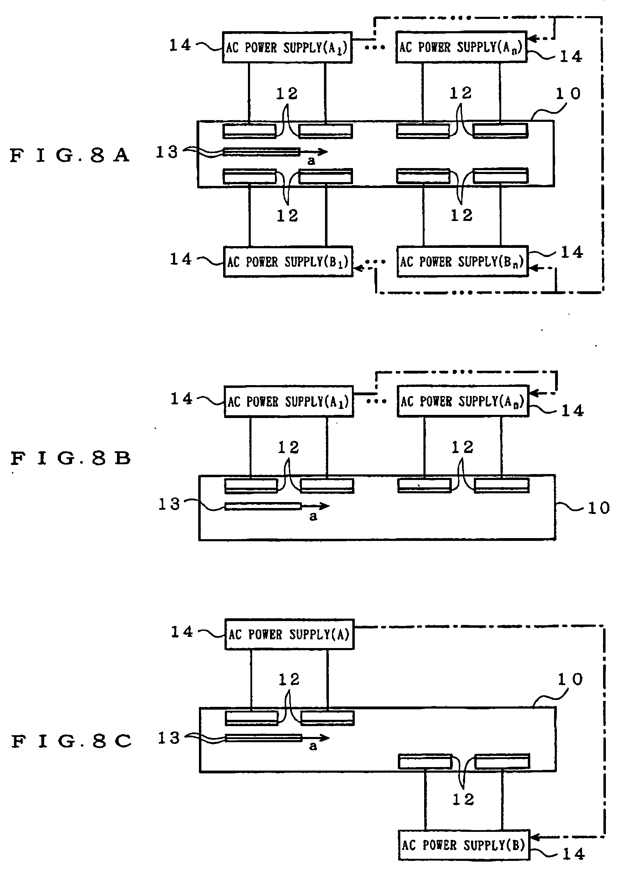

Referring to Figs.8A, 8B and 8C, there are shown another examples 1, 2 and 3 of the arrangement of targets in the chamber shown in Fig.2, respectively

As shown in Fig.8A, a plural sets of targets 12 (each set consists of two targets positioned side by side) are arranged in a row along a proceeding direction (shown by an arrow a) of two glass substrates 13, and arranged oppositely on both sides of the glass substrates 13. According to this arrangement, films may be deposited on the two glass substrates 13 at the same time.

Respective sets of backing plates 11 holding targets 12 arranged on both sides are connected to a corresponding AC cathode power supply 14 (A₁···Aₙ, B₁···Bₙ) provided outside the chamber 10. A power supply (A₁) is a master and power supplies (A₂···Aₙ, B₁···Bₙ) are slaves. The slave power supplies generate alternating voltages by using a oscillator (not shown) provided in the master power supply.

As shown in Fig.8B, a plural sets of targets 12 are arranged in a row on one side of a glass substrate 13 along a proceeding direction (shown by an arrow a) of a glass substrate 13. According to this arrangement, one glass substrates 13 is deposited by a film.

Respective sets of backing plates 11 holding targets 12 arranged on one side are connected to a corresponding AC cathode power supply 14 (A₁···Aₙ) provided outside the chamber 10. A power supply (A₁) is a master and power supplies (A₂···Aₙ) are slaves. The slave power supplies generate alternating voltages by using a oscillator (not shown) provided in the master power supply.

As shown in Fig.8C, two sets of targets 12 are arranged on both sides of the glass substrate 13 along a proceeding direction (shown by an arrow a) of two glass substrates 13. In this case, the two sets of target are not arranged oppositely i.e., are arranged in a zigzag manner. According to this arrangement, films may be deposited on the two glass substrates 13 at the same time.

The two sets of backing plates 11 holding targets 12 arranged in a zigzag manner are connected to corresponding AC cathode power supply 14 (A and B) provided outside the chamber 10. A power supply (A) is a master and a power supply (B) is a slave. The slave power supply generate alternating voltages by using a oscillator (not shown) provided in the master power supply.

The arrangements of the targets 12 are not limited to that described above. Various combination thereof may be implemented. The example has been described in which one power supply is used as a master and all other power supplies are treated as slaves. In this manner, one or more slave power supply 14 may be operated by an oscillator of one master power supply 14.

According to the present invention, all of the cathodes arranged oppositely or in a row in the chamber 10 may implement stable discharges to deposit a film of essentially uniform thickness on the substrate(s). As a result, in the case of two substrates arranged back to back, a productivity of chips becomes two times compared to the case that one substrate is deposited, which leads to substantial reduction of a production cost of chips.

This is because of no frequency shift and phase shift among alternating voltages generated by a plurality of AC cathode by selecting one of power supplies as a master and operating other power supplies by means of a oscillator provided in the master power supply, otherwise the frequency shift and phase shift are caused due to the differences among characteristics of respective oscillators in the case that the respective oscillators provided in the AC cathode power supplies are used.

### Industrial Applicability

According to the sputtering apparatus according to the present invention, when a plurality of cathodes provided in a chamber start discharges at the same time, the discharges are not fluctuated, so that a stable film deposition in possible to a substrate. The present invention is especially applicable to a sputtering apparatus using AC-type cathode power supplies. In the case of two substrates arranged back to back, a productivity of chips becomes two times compared to the case that one substrate is deposited, which leads to substantial reduction of a production cost of chips.

## Claims

1. A sputtering apparatus comprising:
a chamber in which at least one object to be deposited by a film is movably provided;
a plural sets of cathodes are arranged in the chamber, each set consisting of two cathodes positioned side by side and having an opposite polarity; and
a plurality of AC cathode power supplies each connected to corresponding one set of cathodes for generating alternating voltages, frequencies and phases thereof are synchronized so that discharges by means of respective sets of cathodes do not interfere to each other when the alternating voltages are supplied to the cathodes to cause discharges at the same time.

2. A sputtering apparatus according to claim 1, wherein each of the plurality of AC cathode power supplies include one oscillator, and the plurality of AC cathode power supplies generate alternating voltages, respectively, using one oscillator in a'representative AC cathode power supply without using oscillators in other AC cathode power supplies except the representative AC cathode power supply.

3. A sputtering apparatus according to claim 1 or 2, wherein the plural sets of cathodes are arranged on one side of the object along a proceeding direction of the object.

4. A sputtering apparatus according to claim 2, wherein the representative AC cathode supply is that connected one of the plural sets of cathodes, and the other AC cathodes power supplies are that except the representative AC cathode power supply.

5. A sputtering apparatus according to claim 1 or 2, wherein the plural sets of cathodes are arranged on both side of the object along a proceeding direction of the object.

6. A sputtering apparatus according to claim 1 or 2, wherein the plural sets of cathodes are arranged in a zigzag manner on both side of the object along a proceeding direction of the object.

7. A sputtering apparatus according to claim 2, wherein the representative AC cathode supply is that connected one of the plural sets of cathodes arranged on both side of the object, and the other AC cathodes power supplies are that except the representative AC cathode power supply.

8. A sputtering apparatus according to claim 5, wherein the at least one object consist of two objects arranged back to back, and the plural sets of cathodes are arranged on both sides of the two objects so that the targets are opposed to the surface of the two objects.

9. A sputtering apparatus according to claim 6, wherein the at least one object consist of two objects arranged back to back, and the plural sets of cathodes are arranged on both sides of the two objects so that the targets are opposed to the surface of the two objects.
